# FASCICULE DE BREVET EUROPEEN

(11) **EP 3 362 811 B1**
(45) Date de publication et mention de la délivrance du brevet: **28.08.2019**
(21) Numéro de dépôt: 16793963.6
(22) Date de dépôt: 13.10.2016
(51) Int. Cl.: G01R 33/00, B63G 9/06, G06F 17/10, G01V 3/08

(54) **PROCÉDÉ ET DISPOSITIF DE MESURES MAGNÉTIQUES MOBILES POUR CONTRÔLER LA SIGNATURE MAGNÉTIQUE D'UN NAVIRE**
VERFAHREN UND VORRICHTUNG FÜR MOBILE MAGNETISCHE MESSUNGEN ZUR KONTROLLE DER MAGNETISCHEN SIGNATUR EINES SCHIFFES
METHOD AND DEVICE FOR MOBILE MAGNETIC MEASUREMENTS FOR CONTROLLING THE MAGNETIC SIGNATURE OF A VESSEL

(30) Priorité: 16.10.2015 FR 1559920
(43) Date de publication de la demande: 22.08.2018
(73) Titulaire: ECA Robotics, 83130 La Garde (FR)
(72) Inventeur: PERIOU, Jean-Jacques, 83700 Saint Raphaël (FR); MUNSCHY, Marc, 67520 Marlenheim (FR); NOVELLI, Philippe, 44000 Nantes (FR)
(74) Mandataire: Santarelli
(86) Numéro de dépôt international: PCT/FR2016/052654
(87) Numéro de publication internationale: WO 2017/064432

(56) Documents cités:
- WO-A1-87/02324
- FR-A1- 2 704 065
- GB-A- 2 177 511
- JP-A- 2005 195 479

## Description

La présente invention concerne les systèmes de mesures magnétiques pour navires et plus particulièrement un procédé et un dispositif de mesures magnétiques mobiles, par exemple aériennes, pour contrôler la signature magnétique d'un navire.

Tous les bâtiments navals (ou navires) comprenant des matériaux ferromagnétiques ont une signature magnétique qui les rend détectables et identifiables. Une telle identification peut notamment être utilisée pour les suivre, par exemple à partir de systèmes embarqués dans des aéronefs, ou pour déclencher des systèmes de mise à feu d'engins tels que des mines ou des torpilles.

De façon générale, la signature magnétique d'un navire de surface correspond au champ total sur une ligne ou un plan de référence situé sous la quille à une distance égale à la largeur du navire. Elle dépend de la position du navire sur le globe terrestre et de son orientation. Elle représente la déformation du champ magnétique terrestre par l'aimantation du navire.

Ces signatures magnétiques résultent essentiellement de deux composantes, une composante sensiblement constante liée à la magnétisation des matériaux ferromagnétiques utilisés et une partie induite variable qui résulte de la réaction directe de l'influence du champ terrestre sur le navire. La composante variable dépend notamment de l'orientation du navire dans le champ magnétique terrestre et de son inclinaison due au roulis et au tangage.

Pour des navires essentiellement fabriqués dans des matériaux électriquement conducteurs mais non ferromagnétiques, la signature magnétique résulte de courants de Foucault qui perturbent le champ magnétique terrestre.

Pour masquer ces signatures, un traitement magnétique (ou démagnétisation) peut être effectué sur le navire afin de le placer dans un état magnétique contrôlé permettant de réduire la perturbation du champ magnétique terrestre.

Il existe également des systèmes d'immunisation magnétiques permettant de rendre la signature magnétique la plus faible possible (appelés *degaussing* en terminologie anglo-saxonne). Ils sont configurés selon la signature magnétique du navire qui doit être préalablement déterminée et asservis à la position et au cap du navire.

Certains de ces systèmes d'immunisation consistent en des boucles de courant qui créent, sur un plan de référence, un champ magnétique opposé à la signature magnétique du navire. Ces boucles sont typiquement placées autour de la coque, dans trois plans (plan horizontal et plans verticaux longitudinal et latéral), pour corriger l'influence magnétique du navire selon les trois axes de l'espace dans lequel il évolue. Chaque plan peut comprendre de trois à vingt boucles.

Pour connaître la signature magnétique d'un navire et permettre de configurer son système d'immunisation, c'est-à-dire déterminer le courant appliqué à chaque boucle, il existe des stations de mesure en mer comprenant des capteurs disposés sur le fond marin, selon une configuration prédéfinie. Le navire dont la signature doit être déterminée effectue plusieurs passages au-dessus de ces capteurs, selon des trajectoires particulières. Les mesures effectuées à chaque passage du navire sont utilisées pour déterminer un modèle magnétique du navire, par modélisation inverse (permettant de prédire les causes à partir de l'analyse des effets). Ce modèle est utilisé pour calculer l'aimantation du navire selon sa position sur le globe terrestre et sa route. Le système d'immunisation est configuré en fonction de cette aimantation estimée.

Un inconvénient lié à l'utilisation de ces stations de mesures pour configurer un système d'immunisation réside dans la difficulté d'obtenir des mesures récentes (l'aimantation d'un navire évolue avec le temps) et des mesures correspondant au lieu où le navire a besoin de mettre en oeuvre le système d'immunisation (les stations de mesures sont situées sur une base navale pouvant être située loin du terrain d'opération).

Pour pallier à ces inconvénients, il existe des stations mobiles qui peuvent être mises en oeuvre de façon temporaire à l'extérieure d'une base navale.

A titre d'illustration, la demande de brevet GB 2488963 décrit une station mobile pour mesurer la signature magnétique d'un navire et configurer son système d'immunisation. La solution décrite comprend deux ensembles de mesures conçus pour être immergés et mesurer l'influence magnétique du navire passant entre ces deux ensembles. Chacun de ces ensembles comprend plusieurs capteurs magnétiques disposés selon un axe vertical, lorsque la station mobile est opérationnelle, afin de mesurer l'influence magnétique du navire selon plusieurs plans sous-marins horizontaux.

Bien que de telles stations mobiles présentent de nombreux avantages, elles sont difficiles à utiliser, encombrantes lorsqu'elles ne sont pas utilisées et ont un coût élevé.

D'autres stations mobiles sont divulguées dans JP2005195479, WO87/02324, FR2704065 et GB2177511.

Il existe donc un besoin pour des stations mobiles simples d'utilisation, peu encombrantes et d'un coût limité pour mesurer la signature magnétique d'un navire et configurer son système d'immunisation.

L'invention permet de résoudre au moins un des problèmes exposés précédemment.

L'invention a ainsi pour objet un procédé de mesure et de contrôle d'une signature magnétique d'un navire à l'aide d'au moins un engin mobile autonome pourvu d'au moins un capteur magnétique, ce procédé comprenant les étapes suivantes,
- obtention d'une pluralité de mesures magnétiques et de positions associées, les mesures magnétiques obtenues étant en outre associées à un cap du navire ;
- modélisation d'une aimantation du navire en fonction des mesures magnétiques obtenues, des positions associées et d'au moins un cap du navire ;
- estimation d'au moins un champ magnétique selon la modélisation de l'aimantation du navire et d'au moins un paramètre de navigation du navire ; et
- contrôle d'un système de réduction de signature magnétique du navire en fonction dudit au moins un champ magnétique estimé.

Le procédé selon l'invention permet ainsi la mise en oeuvre d'un système réellement portable et facile à utiliser pour effectuer des mesures magnétiques et contrôler des systèmes de réduction de signature magnétique, notamment des systèmes d'immunisation. En outre, le procédé selon l'invention permet la mise en oeuvre d'un système autonome et qui ne nécessite pas de contraintes particulières relatives à l'environnement, telles qu'une profondeur d'eau minimum ou maximum.

Selon un mode de réalisation particulier, ledit au moins un engin mobile autonome comprend des moyens de communication avec le navire, le procédé comprenant en outre une étape de transmission de la pluralité de mesures magnétiques et des positions associées à un système de traitement de données du navire, le système de traitement de données du navire mettant en oeuvre les étapes de modélisation, d'estimation d'au moins un champs magnétique et de contrôle du système de réduction de signature magnétique, le système de réduction de signature magnétique comprenant un système d'immunisation du navire.

Le procédé selon ce mode de réalisation peut donc être mis en oeuvre de façon autonome.

Toujours selon un mode de réalisation particulier, des mesures magnétiques sont obtenues pour au moins deux trajectoires, de préférence rectiligne, rectilignes dudit au moins un engin mobile autonome se déplaçant à proximité du navire. Des mesures magnétiques sont, de préférence, obtenues pour au moins deux caps distincts du navire. Des mesures magnétiques peuvent notamment être obtenues à une hauteur sensiblement constante, déterminée en fonction du tirant d'air ou du tirant d'eau du navire.

Toujours selon un mode de réalisation particulier, ledit au moins un capteur magnétique est un capteur magnétique à trois axes perpendiculaires deux à deux, les mesures magnétiques obtenues représentant la norme d'un vecteur à trois composantes issu du capteur magnétique. Le procédé selon l'invention est ainsi robuste.

Toujours selon un mode de réalisation particulier, le procédé comprend en outre une phase de calibration comprenant une étape de mesure et de correction d'une erreur de zéro, une étape de mesure et de correction d'une erreur de zéro de sensibilité et/ou une étape de mesure et de correction d'une erreur d'orthogonalité des trois axes du capteur magnétique.

Le procédé selon l'invention peut en outre comprendre une phase de compensation pour compenser l'influence magnétique dudit au moins un engin mobile autonome sur ledit au moins un capteur magnétique.

Toujours selon un mode de réalisation particulier, les étapes d'obtention d'une pluralité de mesures magnétiques, de modélisation d'une aimantation du navire, d'estimation d'un champ magnétique et de contrôle d'un système de réduction de signature magnétique sont répétées pour affiner le réglage du système de réduction de signature magnétique.

L'invention a également pour objet un ensemble pour mesurer et contrôler une signature magnétique d'un navire, l'ensemble comprenant au moins un engin mobile autonome pourvu d'au moins un capteur magnétique, ledit au moins un engin mobile autonome étant configuré pour obtenir une pluralité de mesures magnétiques et de positions associées, les mesures magnétiques obtenues étant associées à un cap du navire, l'ensemble comprenant en outre des moyens de calcul configurés pour modéliser une aimantation du navire en fonction de mesures magnétiques obtenues, de positions associées et d'un cap du navire, pour estimer au moins un champ magnétique selon une modélisation de l'aimantation du navire et d'au moins un paramètre de navigation du navire et pour contrôler un système de réduction de signature magnétique en fonction d'au moins un champ magnétique estimé.

L'ensemble selon l'invention est réellement portable et facile à utiliser pour effectuer des mesures magnétiques et contrôler des systèmes d'immunisation. En outre, il ne nécessite pas de contraintes particulières relatives à l'environnement, telles qu'une profondeur d'eau minimum ou maximum.

Selon un mode de réalisation particulier, les moyens de calcul sont en outre configurés pour contrôler des déplacements dudit au moins un engin mobile autonome selon au moins deux trajectoires distinctes, pour, de préférence, au moins deux caps distincts du navire, à une hauteur avantageusement sensiblement constante pouvant par exemple être déterminée en fonction du tirant d'air ou du tirant d'eau du navire.

Ledit au moins un engin mobile autonome peut notamment être un drone aérien, un drone de surface ou un drone sous-marin.

Le système de réduction de signature magnétique peut comprendre un système d'immunisation du navire et/ou un système de démagnétisation du navire.

Selon un mode de réalisation particulier, les moyens de calcul comprennent des moyens de calcul du navire, l'ensemble comprenant en outre des moyens de communication configurés pour transférer la pluralité de mesures magnétiques et de positions associées aux moyens de calcul du navire.

D'autres avantages, buts et caractéristiques de la présente invention ressortent de la description détaillée qui suit, faite à titre d'exemple non limitatif, au regard des dessins annexés dans lesquels :
- les figures 1 et 2 représentent schématiquement un environnement dans lequel l'invention peut être mise en oeuvre, vu de côté et vu de dessus, respectivement, selon un premier mode de réalisation ;
- la figure 3 présente certaines étapes d'un procédé selon un mode de réalisation de l'invention ;
- les figures 4 et 5 représentent schématiquement d'autres exemples d'environnement dans lequel l'invention peut être mise en oeuvre ; et
- la figure 6 illustre un exemple d'un dispositif de traitement d'informations adapté à mettre en oeuvre, au moins partiellement, un mode de réalisation de l'invention.

Selon un mode de réalisation particulier de l'invention, des mesures magnétiques mobiles sont effectuées à l'aide d'un engin mobile autonome tel qu'un drone aérien, par exemple un drone à voilure tournante, un drone de surface ou un drone sous-marin, selon plusieurs trajectoires prédéterminées pour plusieurs caps du navire, ce dernier étant, de préférence, sensiblement immobile avec un cap fixe.

Il est rappelé ici que les effets magnétiques ne sont basés sur aucune propagation et que, par conséquent, les mesures magnétiques sont indépendantes du milieu dans lequel elles sont effectuées (sous réserve que ce milieu ne perturbe pas le champ magnétique du lieu). Il en résulte qu'une mesure effectuée à un même emplacement dans l'eau ou dans l'air est la même.

Les mesures effectuées sont utilisées pour effectuer une modélisation magnétique, à l'aide d'un modèle inverse, par exemple en utilisant un modèle multi-dipolaire.

Cette modélisation permet de calculer un champ magnétique, pour une position et un cap donnés, et, ainsi, contrôler un système de réduction de signature magnétique tel qu'un système de démagnétisation ou un système d'immunisation, par exemple les boucles d'un système d'immunisation d'un navire, en fonction de la position et du cap du navire.

La connaissance du modèle magnétique du navire ainsi que celle du système d'immunisation permet en outre de calculer un risque magnétique et d'affiner la configuration du système d'immunisation selon les circonstances (risque de mines, risque de détection aérienne, ...).

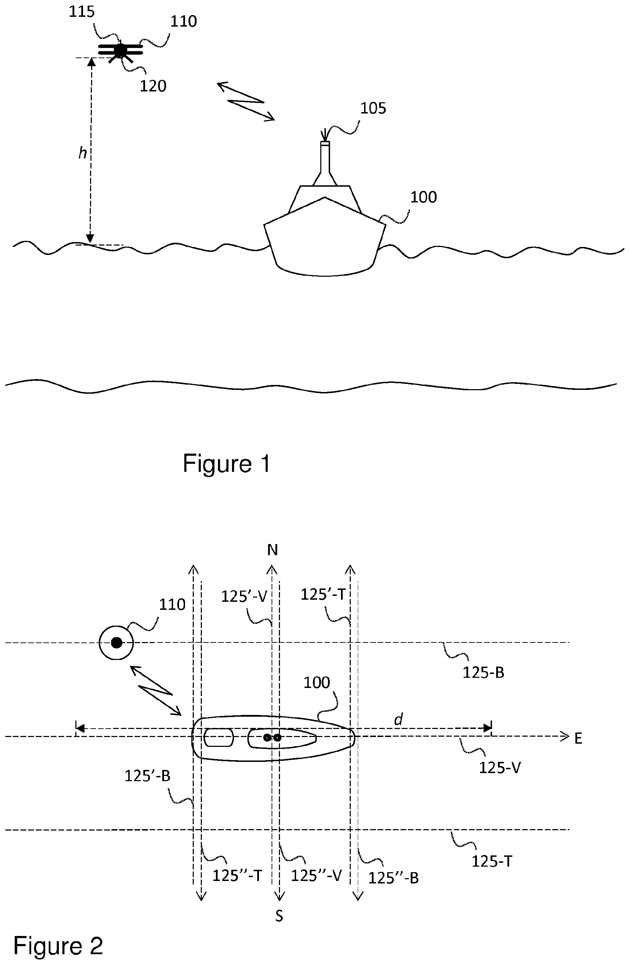

La figure 1 représente schématiquement un environnement dans lequel l'invention peut être mise en oeuvre selon un mode de réalisation particulier.

Comme illustré, un navire 100 comprenant ici des moyens de communication (non représentés) et une antenne de communication 105 est survolé par un engin mobile autonome, ici un drone aérien 110. Ce dernier comprend également des moyens de communication (non représentés) ainsi qu'une antenne de communication 115. Le drone 110 comprend en outre un ou plusieurs capteurs magnétiques 120, de préférence rigidement fixés à lui. A titre d'illustration, ce drone peut être le drone connu sous la référence IT 180, commercialisé par la société ECA.

Le capteur magnétique est ici un capteur magnétique à trois axes, de préférence perpendiculaires deux à deux, permettant de mesurer les trois composantes d'un champ magnétique en un point donné. Il s'agit par exemple d'un capteur de type « flux-gate », par exemple de la société britannique Bartington Instruments, dont la sensibilité est similaire à celle des capteurs utilisés dans les stations sous-marines utilisées pour mesurer la signature magnétique d'un navire.

Par ailleurs, le drone est ici pourvu d'un ou plusieurs capteurs de position permettant d'associer une position à chaque mesure magnétique. De tels capteurs peuvent être des capteurs GPS (sigle de *Global Positioning System* en terminologie anglo-saxonne), des accéléromètres et des gyroscopes ou une combinaison de tels capteurs.

Alternativement (ou de façon complémentaire), le drone, ou plus généralement l'engin mobile autonome, peut être localisé par un système extérieur, par exemple par un système radar installé dans le navire.

Les moyens de communication du navire 100 et du drone 110 leur permettent d'échanger des données, par exemple des instructions de vol et/ou des mesures magnétiques et les positions associées. Il s'agit par exemple de moyens de communication conformes aux standards existants (e.g. 869 MHz pour la télémétrie, 5,8 GHz pour la vidéo et 2,4 GHz pour les données de contrôle à distance), permettant une communication omnidirectionnelle d'environ 3km ou une communication directionnelle d'environ 10km.

Bien entendu, d'autres moyens peuvent être utilisés pour établir une communication entre le navire 100 et le drone 110. A titre d'illustration, le drone 110 peut être programmé avant son vol et enregistrer les mesures effectuées lors du vol, avec les positions associées, qui sont ensuite téléchargées après le vol dans le navire, par exemple à l'aide d'une liaison filaire ou d'une carte mémoire placée dans le drone pour effectuer les enregistrements de données, cette carte étant ensuite transférée dans un système informatique du navire.

Selon un mode de réalisation particulier, le drone a une trajectoire prédéterminée, de préférence à une hauteur constante (notée *h* sur la figure), ou quasi constante. La hauteur est avantageusement choisie pour être supérieure au tirant d'air du navire (ou au tirant d'eau si un drone sous-marin est utilisé) mais pas trop élevée pour permettre l'obtention de mesures précises. Cette hauteur peut être déterminée entre une fois et une fois et demie le tirant d'air (ou du tirant d'eau) du navire.

La trajectoire est avantageusement constituée de segments le long desquels des mesures magnétiques sont effectuées. La trajectoire peut, par exemple, comprendre neuf segments, de préférence rectilignes, correspondant à trois passages selon trois caps du navire.

A titre d'illustration, comme illustré sur la figure 2, le drone effectue trois passages selon trois caps différents à une altitude d'une vingtaine de mètres (l'altitude devant être choisie selon la hauteur du navire pour écarter tout risque d'accrochage). Les trois caps peuvent être, par exemple, l'est (E), le nord (N) et le sud (S). Les trois passages associés à chaque cap sont de préférence parallèles à l'axe longitudinal du navire qui est avantageusement à l'arrêt ou à une vitesse réduite (par exemple entre 2 et 4 noeuds), avec un cap fixe.

Un passage peut être effectué, par exemple, à la verticale du navire (références 125-V pour le cap est, 125'-V pour le cap nord et 125"-V pour le cap sud, sur la figure 2), un autre à bâbord, par exemple à 20 mètres du navire (références 125-B pour le cap est, 125'-B pour le cap nord et 125"-B pour le cap sud, sur la figure 2), et l'autre à tribord, par exemple également à 20 mètres du navire (références 125-T pour le cap est, 125'-T pour le cap nord et 125"-T pour le cap sud, sur la figure 2). D'autres distances peuvent être choisies, notamment selon la taille, en particulier la largeur, du navire.

Chaque passage est effectué sur une distance (notée *d* sur la figure) qui est, de préférence, supérieure à la longueur du navire, par exemple deux fois sa longueur.

Des mesures magnétiques sont effectuées le long de chaque passage, par exemple de façon régulière dans le temps ou le long de la trajectoire suivie. A titre d'exemple, des mesures peuvent être effectuées à une fréquence de 300 Hz, correspondant à un échantillonnage spatial de quelques centimètres. A chaque mesure magnétique effectuée, la position de l'engin mobile autonome est relevée (ou des informations permettant de la déterminée ultérieurement) et mémorisée ou transmise avec la mesure magnétique effectuée.

Les mesures effectuées, qui forment une matrice dans un plan horizontal, sont transmises à un système de traitement de données du navire en temps réel, avec les données de position associées, via un lien de communication sans fil, ou en temps différé.

De façon avantageuse, au moins deux passages sont effectués pour chaque cap et des mesures sont effectuées pour au moins deux caps différents.

Comme décrit précédemment, ces mesures sont utilisées pour produire un modèle magnétique du navire, contrôler un système d'immunisation de celui-ci et, le cas échéant, calculer un risque. A nouveau, les mesures étant indépendantes du milieu dans lequel elles sont effectuées, la modélisation est la même pour des mesures effectuées sous l'eau et pour des mesures effectuées dans l'air.

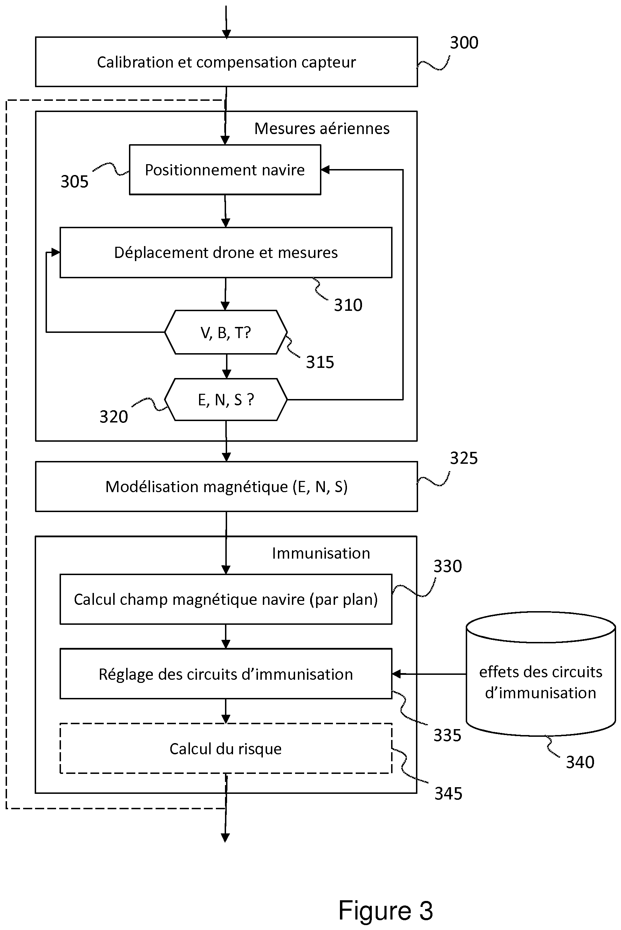

La figure 3 présente certaines étapes d'un procédé selon un mode de réalisation de l'invention. Ces étapes peuvent être regroupées en quatre phases :
- l'initialisation et la calibration ;
- les mesures magnétiques ;
- la modélisation ; et
- l'immunisation.

Comme illustré, une première étape a pour objet la calibration et la compensation du ou des capteurs magnétiques (étape 300).

La calibration a notamment pour objet de déterminer des erreurs du ou des capteurs magnétiques pour les corriger. Selon un mode de réalisation particulier, la calibration comprend une mesure et une correction de l'erreur d'orthogonalité des axes de mesures des composantes magnétiques, une mesure et une correction du zéro et une mesure et une correction de sensibilité.

Il est noté ici que selon une mise en oeuvre particulière, si les trois composantes du champ magnétique sont mesurées en chaque point (le long de la trajectoire de l'engin mobile autonome), seule la norme du vecteur mesuré est utilisée pour modéliser l'aimantation du navire. En effet, il s'avère difficile d'écarter les erreurs de mesure dues aux variations d'orientation du capteur (l'orientation de l'engin mobile autonome ne peut être mesurée suffisamment précisément dans un repère lié au navire). Cependant, le nombre de mesures effectuées permet de compenser l'absence de connaissance des valeurs associées aux trois axes.

Outre la correction de mesure du capteur magnétique, ce dernier est avantageusement compensé pour tenir compte de l'influence magnétique de l'engin mobile autonome (le capteur magnétique ne pouvant généralement, pour des raisons pratiques, être suffisamment écarté de l'engin mobile autonome pour considérer que l'influence de celui-ci est négligeable).

Une telle compensation peut être effectuée par acquisitions successives des valeurs de champ magnétique mesurées pour différentes positions angulaires de l'engin mobile autonome et par l'établissement d'une matrice de correction. Cette opération peut être avantageusement automatisée, par exemple durant une phase initiale de vol qui précède les mesures.

Dans une phase suivante, des mesures magnétiques sont effectuées. A ces fins, le navire est tout d'abord positionné dans une direction prédéterminée (étape 305), par exemple au cap est (E), et l'engin mobile autonome, par exemple le drone 110 illustré sur la figure 1, est envoyé à proximité du navire.

Selon un mode de réalisation particulier, l'engin mobile autonome est programmé avant son envol ou sa mise à l'eau pour suivre une trajectoire prédéterminée. Alternativement, il est contrôlé en temps réel pour suivre celle-ci.

Comme décrit précédemment, l'engin mobile autonome effectue plusieurs passages pour chaque cap du navire. Ainsi, par exemple, il peut effectuer un premier passage à la verticale du navire (V) et effectuer, à une fréquence donnée, des mesures magnétiques (étape 310). Ces mesures sont associées à des mesures de position de l'engin mobile autonome et transmises au navire ou mémorisées pour être transmises ultérieurement.

Un test est ensuite effectué pour déterminer si toutes les mesures nécessaires ont été effectuées pour le cap du navire (étape 315). Si toutes les mesures n'ont pas été effectuées, l'engin mobile autonome fait un nouveau passage et effectue les mesures magnétiques manquantes. Ainsi, par exemple, si seul le passage à la verticale du navire a été effectué, l'engin mobile autonome effectue un nouveau passage, par exemple à bâbord (B), par exemple à 20 mètre du navire. De même, si un passage à la verticale du navire et un passage à bâbord ont été effectués, un nouveau passage, par exemple à tribord (T), par exemple à 20 mètre du navire, est effectué.

Un test est ensuite effectué pour déterminer si toutes les mesures nécessaires ont été effectuées pour tous les caps du navire (étape 320). Si toutes les mesures n'ont pas été effectuées, le navire est positionné dans une nouvelle direction prédéterminée (étape 305), par exemple au cap nord (N) ou au cap sud (S). L'engin mobile autonome effectue alors plusieurs passages pour le nouveau cap du navire. A nouveau, il peut effectuer un premier passage à la verticale du navire (V), suivi d'un passage à bâbord et d'un passage à tribord. Des mesures sont effectuées lors de chacun de ces passages et associées à des mesures de position de l'engin mobile autonome.

Lorsque toutes les mesures ont été effectuées (selon les différents caps prédéterminés et les différents passages), l'aimantation du navire est modélisée en fonction des caps pour lesquels des mesures ont été effectuées (étape 325).

Comme décrit précédemment, une telle modélisation peut être effectuée selon le modèle inverse en utilisant, par exemple, un modèle multi-dipolaire. La modélisation est ici effectuée de façon standard, en utilisant les mesures magnétiques effectuées et les positions associées, étant rappelé que le milieu dans lequel les mesures sont effectuées, par exemple l'air ou l'eau, est sans influence.

La modélisation de l'aimantation du navire peut alors être utilisée pour contrôler un système de réduction de signature magnétique, en particulier pour régler des circuits d'immunisation du navire.

A ces fins, il convient d'estimer le champ magnétique créé par le navire sur un ou plusieurs plans donnés, selon la position du navire et son cap (étape 330). Le choix des plans dans lesquels est estimé le champ magnétique est déterminé selon les risques encourus par le navire (risques de mines, risques d'attaques aériennes, ...).

Le champ magnétique créé par le navire est alors comparé aux effets pouvant être produits par les circuits d'immunisation, selon différentes configurations possibles, pour trouver le réglage permettant de compenser le plus précisément le champ magnétique créé par le navire dans les plans choisis, par exemple par extrapolation des réglages correspondants aux effets les plus proches des effets désirés (étape 335).

Les effets pouvant être produits par les circuits d'immunisation peuvent être mémorisés dans une base de données 340 du navire ou accessibles, sur un site distant, par le système de traitement de données du navire.

Les effets sont déterminés, lors de la construction du navire, ultérieurement, ou de façon répétée, en comparant l'anomalie magnétique du navire lorsque les circuits d'immunisation sont désactivés et lorsqu'ils sont activés avec des réglages particuliers, en tenant compte de la position et du cap du navire.

Selon les plans dans lesquels le champ magnétique du navire a été estimé et les réglages des circuits d'immunisation, il est possible de calculer un risque lié à la détectabilité de l'anomalie magnétique provoquée par le navire en dépit de l'utilisation des circuits d'immunisation (étape 345).

Il est observé ici que les étapes d'obtention de mesures magnétiques, de modélisation de l'aimantation du navire et de réglage des circuits d'immunisation peuvent être répétées, en utilisant les circuits d'immunisation, pour affiner ce réglage, comme suggéré par la flèche en trait pointillé.

Il est également observé ici que le ou les champs magnétiques calculés peuvent être utilisés pour contrôler d'autres types de systèmes de réduction de signature magnétique, de façon combinée ou alternative, par exemple un système de démagnétisation du navire.

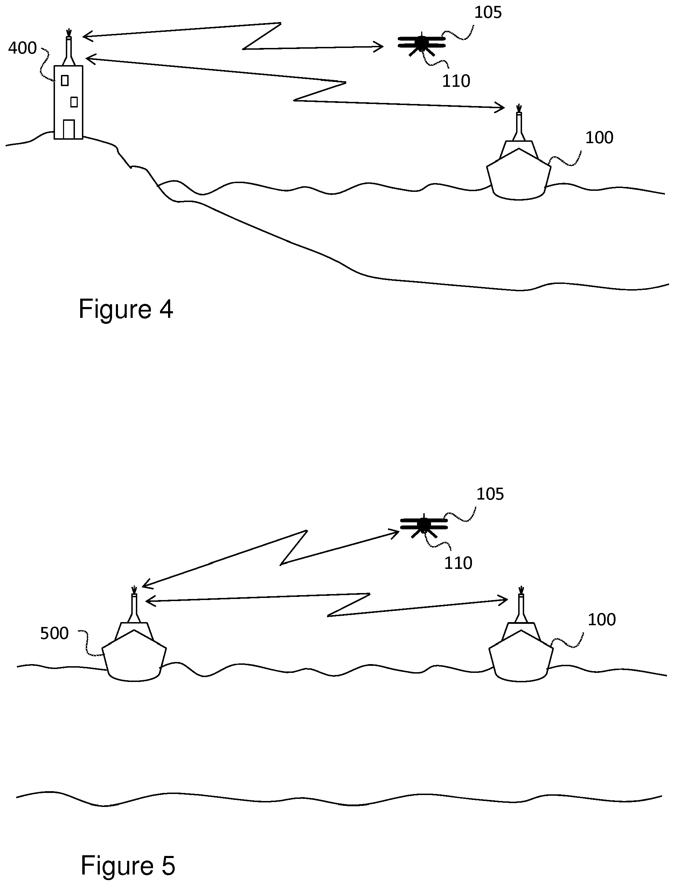

Les figures 4 et 5 représentent schématiquement d'autres exemples d'environnement dans lequel l'invention peut être mise en oeuvre, selon lesquels les échanges de données entre le navire et l'engin mobile autonome sont indirects.

Comme représenté sur la figure 4, l'engin mobile autonome pourvu d'un capteur magnétique peut être opéré depuis une station fixe, référencée ici 400, au sol. Les mesures magnétiques effectuées par l'engin mobile autonome ainsi que les positions auxquelles sont effectuées ces mesures sont alors transmises à la station au sol, par un lien de communication radio ou à la fin de la mission de mesures.

Ces données peuvent alors être transmises au navire dont l'aimantation doit être modélisée afin qu'il puisse effectuer cette modélisation. Alternativement, la modélisation peut être effectuée par la station au sol qui transmet alors la modélisation magnétique du navire à ce dernier. Alternativement encore, la modélisation peut être effectuée par la station au sol ainsi que le calcul du champ magnétique créé par le navire après que ce dernier ait indiqué sa position et son cap. La station au sol transmet alors des données représentatives du champ magnétique créé au navire pour permettre à ce dernier de régler ses circuits d'immunisation. Le réglage des circuits d'immunisation peut être effectué par la station au sol ou par le navire.

La figure 5 représente une variante de la figure 4 selon laquelle la station au sol est remplacée par un navire 500 distinct du navire 100 dont l'aimantation est modélisée aux fin de régler ses circuits d'immunisation.

Il existe naturellement d'autres configurations faisant appel, par exemple, à une ou plusieurs stations au sol et à un ou plusieurs navires distincts du navire dont l'aimantation est modélisée aux fin de régler ses circuits d'immunisation.

Il est également observé ici que si les mesures magnétiques sont de préférence effectuées lorsque le navire est sensiblement immobile, il est néanmoins possible d'effectuer ces mesures lorsque le navire est en mouvement. Il convient alors d'associer, pour chaque mesure effectuée, la valeur de la mesure avec la position de l'engin mobile autonome et celle du navire pour tenir compte du déplacement du navire lors de la modélisation magnétique.

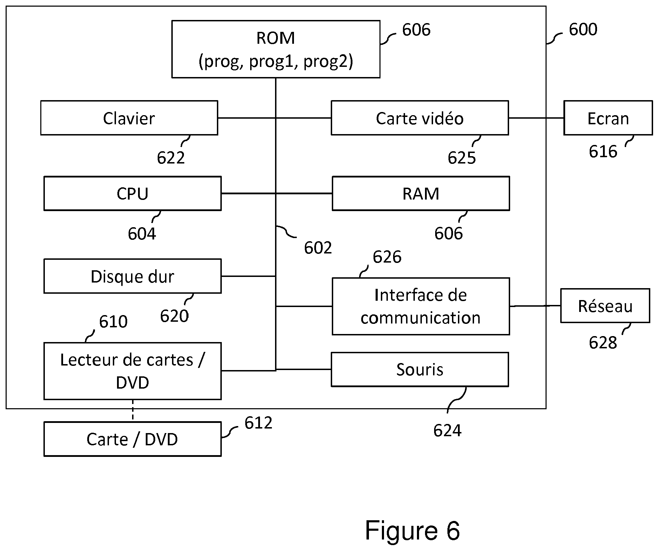

La figure 6 illustre un exemple de dispositif pouvant être utilisé pour mettre en oeuvre, au moins partiellement, un mode de réalisation, notamment des étapes décrites en référence à la figure 3.

Le dispositif 600 est par exemple un serveur, un ordinateur ou un assistant calculateur.

Le dispositif 600 comporte de préférence un bus de communication 602 auquel sont reliés :
- une unité centrale de traitement ou microprocesseur 604 (CPU, sigle de *Central Processing Unit* en terminologie anglo-saxonne) ;
- une mémoire morte 606 (ROM, acronyme de *Read Only Memory* en terminologie anglo-saxonne) pouvant comporter le système d'exploitation et des programmes tels que "Prog" ;
- une mémoire vive ou mémoire cache 608 (RAM, acronyme de *Random Access Memory* en terminologie anglo-saxonne) comportant des registres adaptés à enregistrer des variables et paramètres créés et modifiés au cours de l'exécution des programmes précités ;
- un lecteur 610 de support amovible de stockage 612 tel qu'une carte mémoire ou un disque, par exemple un disque DVD ; et
- une carte graphique 614 reliée à un écran 616.

Optionnellement, le dispositif 600 peut également disposer des éléments suivants :
- un disque dur 620 pouvant comporter les programmes "Prog" précités et des données traitées ou à traiter selon l'invention ;
- un clavier 622 et une souris 624 ou tout autre dispositif de pointage comme un crayon optique, un écran tactile ou une télécommande permettant à l'utilisateur d'interagir avec les programmes selon l'invention ; et
- une interface de communication 626 reliée à un réseau de communication distribué 628, par exemple un réseau de communication sans fil et/ou un réseau de communication local, l'interface étant apte à transmettre et à recevoir des données.

Le bus de communication permet la communication et l'interopérabilité entre les différents éléments inclus dans le dispositif 600 ou reliés à lui. La représentation du bus n'est pas limitative et, notamment, l'unité centrale est susceptible de communiquer des instructions à tout élément du dispositif 600 directement ou par l'intermédiaire d'un autre élément du dispositif 600.

Le code exécutable de chaque programme permettant à l'appareil programmable de mettre en oeuvre les processus selon l'invention, en particulier pour modéliser l'aimantation d'un navire, pour calculer un champ magnétique selon un ou plusieurs plans prédéterminés et/ou régler des circuits d'immunisation, peut être stocké, par exemple, dans le disque dur 620 ou en mémoire morte 606.

Selon une variante, le code exécutable des programmes pourra être reçu par l'intermédiaire du réseau de communication 628, via l'interface 626, pour être stocké de façon identique à celle décrite précédemment.

De manière plus générale, le ou les programmes pourront être chargés dans un des moyens de stockage du dispositif 600 avant d'être exécutés.

L'unité centrale 604 va commander et diriger l'exécution des instructions ou portions de code logiciel du ou des programmes selon l'invention, instructions qui sont stockées dans le disque dur 620 ou dans la mémoire morte 606 ou bien dans les autres éléments de stockage précités. Lors de la mise sous tension, le ou les programmes qui sont stockés dans une mémoire non volatile, par exemple le disque dur 620 ou la mémoire morte 606, sont transférés dans la mémoire vive 608 qui contient alors le code exécutable du ou des programmes selon l'invention, ainsi que des registres pour mémoriser les variables et paramètres nécessaires à la mise en oeuvre de l'invention.

Naturellement, pour satisfaire des besoins spécifiques, une personne compétente dans le domaine de l'invention pourra appliquer des modifications dans la description précédente. La présente invention ne se limite pas aux formes de réalisation décrites, d'autres variantes et combinaisons de caractéristiques sont possibles.

La présente invention a été décrite et illustrée dans la présente description détaillée en référence aux figures jointes. Toutefois, la présente invention ne se limite pas aux formes de réalisation présentées. D'autres variantes et modes de réalisation peuvent être déduits et mis en oeuvre par la personne compétente dans le domaine de l'invention à la lecture de la présente description et des figures annexées.

En particulier, il est observé ici que si l'invention peut, selon certains modes de réalisation, être mise en oeuvre à l'aide d'un drone aérien, il est également possible d'utiliser un drone sous-marin ou un drone de surface pour effectuer les mesures magnétiques.

De même, l'invention peut, selon certains modes de réalisation, être mise en oeuvre avec un engin mobile autonome comprenant plusieurs parties reliées entre elles de façon mobile. Un tel engin mobile autonome peut notamment comprendre une partie ayant le ou les composants de mesure magnétique, une partie ayant le ou les éléments de guidage et, le cas échéant, une partie ayant des moyens de communication.

Il est également observé que les mesures magnétiques peuvent être effectuées par plusieurs engins mobiles autonomes de même type ou de types différents. Il est ainsi possible d'utiliser un drone aérien pour effectuer une partie des mesures et un autre drone, par exemple un drone aérien, un drone de surface ou un drone sous-marin pour effectuer une autre partie des mesures magnétiques.

Enfin, le ou les engins mobiles autonomes utilisés peuvent comprendre un ou plusieurs capteurs magnétiques. Lorsqu'un engin mobile autonome comprend plusieurs capteurs magnétiques, les données issues de chacun de ces capteurs peuvent être transmises pour être traitées et pour modéliser une aimantation du navire ou peuvent être consolidées avant d'être transmises afin de limiter le nombre de données transmises. Une telle consolidation peut être effectuée de façon classique, par exemple en moyennant, avec ou sans pondération, les données obtenues par chaque capteur.

Dans les revendications, le terme « comporter » n'exclut pas d'autres éléments ou d'autres étapes. L'article indéfini « un » n'exclut pas le pluriel. Un seul processeur ou plusieurs autres unités peuvent être utilisées pour mettre en oeuvre l'invention. Les différentes caractéristiques présentées et/ou revendiquées peuvent être avantageusement combinées. Leur présence dans la description ou dans des revendications dépendantes différentes n'exclut pas, en effet, la possibilité de les combiner. Les signes de référence ne sauraient être compris comme limitant la portée de l'invention.

## Revendications

1. Procédé de mesure et de contrôle d'une signature magnétique d'un navire (100) à l'aide d'au moins un drone (110) pourvu d'au moins un capteur magnétique (120), ce procédé étant **caractérisé en ce qu'**il comprend les étapes suivantes,
- obtention (310) d'une pluralité de mesures magnétiques et de positions associées, les mesures magnétiques obtenues étant en outre associées à un cap du navire ;
- modélisation (325) d'une aimantation du navire en fonction des mesures magnétiques obtenues, des positions associées et d'au moins un cap du navire ;
- estimation (330) d'au moins un champ magnétique selon la modélisation de l'aimantation du navire et d'au moins un paramètre de navigation du navire ; et
- contrôle (335) d'un système de réduction de signature magnétique du navire en fonction dudit au moins un champ magnétique estimé, **caractérisé en ce que** le drone est un drone aérien.

2. Procédé selon la revendication 1 selon lequel ledit au moins un drone aérien comprend des moyens de communication avec le navire, le procédé comprenant en outre une étape de transmission de la pluralité de mesures magnétiques et des positions associées à un système de traitement de données du navire, le système de traitement de données du navire mettant en oeuvre les étapes de modélisation, d'estimation d'au moins un champs magnétique et de contrôle du système de réduction de signature magnétique, le système de réduction de signature magnétique comprenant un système d'immunisation du navire.

3. Procédé selon la revendication 1 ou la revendication 2 selon lequel des mesures magnétiques sont obtenues pour au moins deux trajectoires rectilignes dudit au moins un drone aérien se déplaçant à proximité du navire.

4. Procédé selon l'une quelconque des revendications 1 à 3 selon lequel des mesures magnétiques sont obtenues pour au moins deux caps distincts du navire.

5. Procédé selon l'une quelconque des revendications 1 à 4 selon lequel des mesures magnétiques sont obtenues à une hauteur sensiblement constante déterminée en fonction du tirant d'air ou du tirant d'eau du navire.

6. Procédé selon l'une quelconque des revendications 1 à 5 selon lequel ledit au moins un capteur magnétique est un capteur magnétique à trois axes perpendiculaires deux à deux, les mesures magnétiques obtenues représentant la norme d'un vecteur à trois composantes issu du capteur magnétique.

7. Procédé selon la revendication 6 comprenant en outre une phase de calibration (300) comprenant une étape de mesure et de correction d'une erreur de zéro, une étape de mesure et de correction d'une erreur de zéro de sensibilité et/ou une étape de mesure et de correction d'une erreur d'orthogonalité des trois axes du capteur magnétique.

8. Procédé selon l'une quelconque des revendications 1 à 7 comprenant en outre une phase de compensation pour compenser l'influence magnétique dudit au moins un drone aérien sur ledit au moins un capteur magnétique.

9. Procédé selon l'une quelconque des revendications 1 à 8 selon lequel les étapes d'obtention d'une pluralité de mesures magnétiques, de modélisation d'une aimantation du navire, d'estimation d'un champ magnétique et de contrôle d'un système de réduction de signature magnétique sont répétées pour affiner le réglage du système de réduction de signature magnétique.

10. Ensemble pour mesurer et contrôler une signature magnétique d'un navire (100), l'ensemble comprenant au moins un drone (110) pourvu d'au moins un capteur magnétique (120), ledit au moins un drone aérien étant configuré pour obtenir (310) une pluralité de mesures magnétiques et de positions associées, les mesures magnétiques obtenues étant associées à un cap du navire, l'ensemble comprenant en outre des moyens de calcul configurés pour modéliser (325) une aimantation du navire en fonction de mesures magnétiques obtenues, de positions associées et d'un cap du navire, pour estimer (330) au moins un champ magnétique selon une modélisation de l'aimantation du navire et d'au moins un paramètre de navigation du navire et pour contrôler (335) un système de réduction de signature magnétique en fonction d'au moins un champ magnétique estimé, **caractérisé en ce que** le drone est un drone aérien.

11. Ensemble selon la revendication 10 selon lequel les moyens de calcul sont en outre configurés pour contrôler des déplacements dudit au moins un drone aérien selon au moins deux trajectoires distinctes pour au moins deux caps distincts du navire, à une hauteur sensiblement constante déterminée en fonction du tirant d'air ou du tirant d'eau du navire.

12. Ensemble selon la revendication 10 ou la revendication 11 selon lequel le système de réduction de signature magnétique comprend un système d'immunisation du navire.

13. Ensemble selon l'une quelconque des revendications 10 à 12 selon lequel les moyens de calcul comprennent des moyens de calcul du navire, l'ensemble comprenant en outre des moyens de communication configurés pour transférer la pluralité de mesures magnétiques et de positions associées aux moyens de calcul du navire.

14. Ensemble selon la revendication 10 ou la revendication 11 selon lequel le système de réduction de signature magnétique comprend un système de démagnétisation du navire.

## Patentansprüche

1. Verfahren zur Messung und Steuerung einer magnetischen Signatur eines Schiffes (100) unter Verwendung zumindest einer Drohne (110), die mit zumindest einem Magnetsensor (120) versehen ist, wobei das Verfahren **dadurch gekennzeichnet ist, dass** es die folgenden Schritte umfasst:
- Erhalten (310) mehrerer magnetischer Messungen und zugehöriger Positionen, wobei die erhaltenen magnetischen Messungen ferner einer Fahrtrichtung des Schiffes zugeordnet sind;
- Modellierung (325) einer Magnetisierung des Schiffes anhand der erhaltenen magnetischen Messungen, der zugehörigen Positionen und zumindest einer Fahrtrichtung des Schiffes;
- Schätzen (330) von zumindest einem Magnetfeld gemäß der Modellierung der Magnetisierung des Schiffes und von zumindest einem Navigationsparameter des Schiffes; und
- Steuern (335) eines Systems zur Verringerung der magnetischen Signatur des Schiffes anhand des zumindest einen geschätzten Magnetfeldes,
**dadurch gekennzeichnet, dass**
die Drohne eine Luftdrohne ist.

2. Verfahren nach Anspruch 1, wobei die zumindest eine Luftdrohne Kommunikationsmittel zur Kommunikation mit dem Schiff enthält, wobei das Verfahren ferner einen Schritt des Übertragens der mehreren magnetischen Messungen und der zugehörigen Positionen an ein Datenverarbeitungssystem des Schiffes enthält, wobei das Datenverarbeitungssystem des Schiffes die Schritte des Modellierens, des Schätzens von zumindest einem Magnetfeld und des Steuerns des Systems zur Verringerung der magnetischen Signatur des Schiffes durchführt, wobei das System zur Verringerung der magnetischen Signatur ein System zur Immunisierung des Schiffes enthält.

3. Verfahren nach Anspruch 1 oder Anspruch 2, wobei die magnetischen Messungen für zumindest zwei geradlinige Bewegungsbahnen der zumindest einen Luftdrohne, die sich in der Nähe des Schiffes bewegt, erhalten werden.

4. Verfahren nach einem der Ansprüche 1 bis 3, wobei die magnetischen Messungen für zumindest zwei verschiedene Fahrtrichtungen des Schiffes erhalten werden.

5. Verfahren nach einem der Ansprüche 1 bis 4, wobei die magnetischen Messungen in einer im Wesentlichen konstanten Höhe, die in Abhängigkeit von der Überwasserhöhe bzw. dem Tiefgang des Schiffes bestimmt wird, erhalten werden.

6. Verfahren nach einem der Ansprüche 1 bis 5, wobei der zumindest eine Magnetsensor ein Magnetsensor mit drei Achsen ist, von denen jeweils zwei senkrecht zueinander verlaufen, wobei die erhaltenen magnetischen Messungen die Norm eines vom Magnetsensor stammenden Vektors mit drei Komponenten darstellen.

7. Verfahren nach Anspruch 6, ferner umfassend eine Kalibrationsphase (300) mit einem Schritt des Messens und Korrigierens von einem Nullfehler, einen Schritt des Messens und Korrigierens von einem Nullfehler der Empfindlichkeit und/oder einen Schritt des Messens und Korrigierens von einem Orthogonalitätsfehler der drei Achsen des Magnetsensors.

8. Verfahren nach einem der Ansprüche 1 bis 7, ferner umfassend eine Kompensationsphase zum Kompensieren von dem magnetischen Einfluss der zumindest einen Luftdrohne auf den zumindest einen Magnetsensor.

9. Verfahren nach einem der Ansprüche 1 bis 8, wobei die Schritte des Erhaltens mehrerer magnetischer Messungen, des Modellierens einer Magnetisierung des Schiffes, des Schätzens eines Magnetfeldes und des Steuerns eines Systems zur Verringerung der magnetischen Signatur zur Feinabstimmung des Systems zur Verringerung der magnetischen Signatur wiederholt werden.

10. Anordnung zur Messung und Steuerung einer magnetischen Signatur eines Schiffes (100), wobei die Anordnung zumindest eine Drohne (110) enthält, die mit zumindest einem Magnetsensor (120) versehen ist, wobei die zumindest eine Luftdrohne dazu ausgelegt ist, mehrere magnetische Messungen und zugehörige Postionen zu erhalten (310), wobei die erhaltenen magnetischen Messungen einer Fahrtrichtung des Schiffes zugeordnet werden, wobei die Anordnung ferner Rechenmittel enthält, die dazu ausgelegt sind, eine Magnetisierung des Schiffes anhand der erhaltenen magnetischen Messungen, der zugehörigen Positionen und einer Fahrtrichtung des Schiffes zu modellieren (325), zumindest ein Magnetfeld gemäß einer Modellierung der Magnetisierung des Schiffes und zumindest einen Navigationsparameter des Schiffes zu schätzen (330) und ein System zur Verringerung der magnetischen Signatur anhand von zumindest einem geschätzten Magnetfeld zu steuern (335),
**dadurch gekennzeichnet, dass**
die Drohne eine Luftdrohne ist.

11. Anordnung nach Anspruch 10, wobei die Rechenmittel ferner dazu ausgelegt sind, Bewegungen der zumindest einen Luftdrohne entlang von zumindest zwei verschiedenen Bewegungsbahnen für zumindest zwei verschiedene Fahrtrichtungen des Schiffes in einer im Wesentlichen konstanten Höhe, die in Abhängigkeit von der Überwasserhöhe bzw. dem Tiefgang des Schiffes bestimmt ist, zu steuern.

12. Anordnung nach Anspruch 10 oder Anspruch 11, wobei das System zur Verringerung der magnetischen Signatur ein System zur Immunisierung des Schiffes enthält.

13. Anordnung nach einem der Ansprüche 10 bis 12, wobei die Rechenmittel Schiffsberechnungsmittel enthalten, wobei die Anordnung ferner Kommunikationsmittel enthält, die dazu ausgelegt sind, die mehreren magnetischen Messungen und zugehörigen Positionen an die Schiffsberechnungsmittel zu übertragen.

14. Anordnung nach Anspruch 10 oder Anspruch 11, wobei das System zur Verringerung der magnetischen Signatur ein System zum Entmagnetisieren des Schiffes enthält.

## Claims

1. A method for measuring and controlling a magnetic signature of a ship (100) using at least one drone (110) provided with at least one magnetic sensor (120), this method being **characterized in that** it comprises the following steps,
- obtaining (310) a plurality of magnetic measurements and associated positions, the obtained magnetic measurements further being associated with a heading of the ship;
- modelling (325) magnetization of the ship as a function of the obtained magnetic measurements, associated positions and at least one heading of the ship;
- estimating (330) at least one magnetic field according to the modelling of the magnetization of the ship and of at least one navigation parameter of the ship; and
- controlling (335) a magnetic signature reduction system of the ship as a function of said at least one estimated magnetic field,
wherein the at least one drone is an aerial drone.

2. The method according to claim 1 according to which the at least one aerial drone comprises means for communicating with the ship, the method further comprising a step of transmitting the plurality of magnetic measurements and the associated positions with a data-processing system of the ship, the data-processing system of the ship performing the steps of modelling, estimating at least one magnetic field and of controlling the magnetic signature reduction system, the magnetic signature reduction system comprising a degaussing system of the ship.

3. The method according to claim 1 or claim 2 according to which magnetic measurements are obtained for at least two rectilinear trajectories of the at least one aerial drone moving near the ship.

4. The method according to any one of claims 1 to 3 according to which magnetic measurements are obtained for at least two separate headings of the ship.

5. The method according to any one of claims 1 to 4 according to which magnetic measurements are obtained at a substantially constant height determined as a function of the air draught or of the draught of the ship.

6. The method according to any one of claims 1 to 5 according to which said at least one magnetic sensor is a three axe magnetic sensor having three perpendicular axes in pairs, the obtained magnetic measurements representing the norm of a vector having three components coming from the magnetic sensor.

7. The method according to claim 6 further comprising a calibration phase (300) comprising a step of measuring and correcting a zero error, a step of measuring and correcting a sensitivity zero error and/or a step of measuring and correcting an orthogonality error of the three axes of the magnetic sensor.

8. The method according to any one of claims 1 to 7 further comprising a compensation phase for compensating the magnetic influence of the at least one aerial drone on said at least one magnetic sensor.

9. The method according to any one of claims 1 to 8 according to which the steps of obtaining a plurality of magnetic measurements, of modelling magnetization of the ship, of estimating a magnetic field and of controlling a magnetic signature reduction system are repeated to refine the setting of the magnetic signature reduction system.

10. A set for measuring and controlling a magnetic signature of a ship (100), the set comprising at least one drone (110) provided with of at least one magnetic sensor (120), said at least one drone being configured to obtain (310) a plurality of magnetic measurements and associated positions, the obtained magnetic measurements being associated with a heading of the ship, the set further comprising calculation means configured to model (325) magnetization of the ship as a function of obtained magnetic measurements, associated positions and a heading of the ship, to estimate (330) at least one magnetic field according to a modelling of the magnetization of the ship and of at least one navigation parameter of the ship and to control (335) a magnetic signature reduction system as a function of at least one estimated magnetic field, wherein the at least one drone is an aerial drone.

11. The set according to claim 10 according to which the calculation means are further configured to control displacements of the at least one aerial drone according to at least two separate trajectories for at least two separate headings of the ship, at a substantially constant height determined as a function of the air draught or of the draught of the ship.

12. The set according to claim 10 or claim 11 according to which the magnetic signature reduction system comprises a degaussing system of the ship.

13. The set according to any one of claims 10 to 12 according to which the calculation means comprise calculation means of the ship, the set further comprising communication means configured to transfer the plurality of magnetic measurements and associated positions to the calculation means of the ship.

14. The set according to claim 10 or claim 11 according to which the magnetic signature reduction system comprises a demagnetization system of the ship.
